# EUROPEAN PATENT APPLICATION

(11) **EP 3 190 619 A1**
(43) Date of publication of application: **12.07.2017**
(21) Application number: 16150446.9
(22) Date of filing: 07.01.2016
(51) Int. Cl.: H01L 27/144, H01L 27/146

(54) **A PHOTODETECTOR APPARATUS AND ASSOCIATED METHODS**

(71) Applicant: Nokia Technologies Oy, 02610 Espoo (FI)
(72) Inventor: Bessonov, Alexander, Cambridge, CB1 3HR (GB); Allen, Mark, Great Cambourne, CB23 6BA (GB); White, Richard, Huntingdon, PE28 9DY (GB)
(74) Representative: Potter Clarkson LLP

(57) **Abstract**

An apparatus comprising a stack formed from outer first and second electrode layers and an intermediate third electrode layer, with a memristive layer positioned between the outer first and intermediate third electrode layers and a photoactive layer positioned between the outer second and intermediate third electrode layers,
wherein the outer first and second electrode layers are connected to a power supply to enable the application of a voltage to the memristive layer to change its resistance when the photoactive layer is exposed to incident electromagnetic radiation, and
wherein the outer first and intermediate third electrode layers are connected to a readout circuit to enable the resistance of the memristive layer to be determined, the resistance of the memristive layer providing an indication of one or more of the presence and magnitude of the incident electromagnetic radiation.

## Description

### Technical Field

The present disclosure relates particularly to photodetectors, associated methods and apparatus. Certain embodiments specifically concern an apparatus comprising a stack formed from outer first and second electrode layers and an intermediate third electrode layer, with a memristive layer positioned between the outer first and intermediate third electrode layers and a photoactive layer positioned between the outer second and intermediate third electrode layers. In these embodiments, the outer first and second electrode layers are connected to a power supply to enable the application of a voltage to the memristive layer to change its resistance when the photoactive layer is exposed to incident electromagnetic radiation, and the outer first and intermediate third electrode layers are connected to a readout circuit to enable the resistance of the memristive layer to be determined to provide an indication of one or more of the presence and magnitude of the incident electromagnetic radiation.

Some embodiments may relate to portable electronic devices, in particular, so-called hand-portable electronic devices which may be hand-held in use (although they may be placed in a cradle in use). Such hand-portable electronic devices include so-called Personal Digital Assistants (PDAs) and tablet PCs. The portable electronic devices/apparatus according to one or more disclosed example aspects/embodiments may provide one or more audio/text/video communication functions (e.g. telecommunication, video-communication, and/or text transmission, Short Message Service (SMS)/ Multimedia Message Service (MMS)/emailing functions, interactive/non-interactive viewing functions (e.g. web-browsing, navigation, TV/program viewing functions), music recording/playing functions (e.g. MP3 or other format and/or (FM/AM) radio broadcast recording/playing), downloading/sending of data functions, image capture function (e.g. using a (e.g. in-built) digital camera), and gaming functions.

### Background

Research is currently being done to develop new photodetector devices.

The listing or discussion of a prior-published document or any background in this specification should not necessarily be taken as an acknowledgement that the document or background is part of the state of the art or is common general knowledge.

### Summary

According to a first aspect, there is provided an apparatus comprising a stack formed from outer first and second electrode layers and an intermediate third electrode layer, with a memristive layer positioned between the outer first and intermediate third electrode layers and a photoactive layer positioned between the outer second and intermediate third electrode layers,
wherein the outer first and second electrode layers are connected to a power supply to enable the application of a voltage to the memristive layer to change its resistance when the photoactive layer is exposed to incident electromagnetic radiation, and
wherein the outer first and intermediate third electrode layers are connected to a readout circuit to enable the resistance of the memristive layer to be determined, the resistance of the memristive layer providing an indication of one or more of the presence and magnitude of the incident electromagnetic radiation.

The photoactive layer may be configured to exhibit a decrease in resistance on exposure to the incident electromagnetic radiation, and the decrease in resistance may allow the voltage from the power supply to be applied to the memristive layer to change its resistance.

The photoactive layer may comprise a semiconducting quantum dot material configured to generate electron-hole pairs on exposure to the incident electromagnetic radiation to cause the decrease in resistance.

The semiconducting quantum dot material may be configured to form a photoconductor.

The semiconducting quantum dot material may comprise first and second semiconducting quantum dot materials configured to form a photodiode.

The semiconducting quantum dot material may be configured to form a Schottky photodiode with the outer second electrode layer or the intermediate third electrode layer.

The intermediate third electrode layer may comprise a first sub-layer adjacent to the memristive layer and a second sub-layer adjacent to the photoactive layer, and the first sub-layer may have a lower work function than the second sub-layer.

The first and second sub-layers may be separated by a third sub-layer, the first and second sub-layers may be configured for interfacing the respective memristive and photoactive layers, and the third sub-layer may be configured for reading out the resistance of the memristive layer.

The intermediate third electrode layer may comprise one or more metal nanowires.

The outer second electrode layer may comprise one or more metal nanowires.

The outer second electrode layer may be substantially transparent to the incident electromagnetic radiation.

The power supply may be configured to apply a steady voltage to switch the memristive layer from a first resistive state to a second lower resistance state, or a pulsed voltage to vary the resistance of the memristive layer more gradually in a step-wise manner.

The apparatus may comprise a plurality of stacks configured to form a one, two or three dimensional array.

The plurality of stacks may share a common outer second electrode layer, and the outer first and intermediate third electrode layers of each stack may be individually addressable to enable the resistance of a particular memristive layer of the array to be determined.

One or more of the material, size and shape of the semiconducting quantum dot material may be configured such that the electron-hole pairs are generated on exposure to at least one of the following types of electromagnetic radiation: x-rays, visible light, infrared, ultraviolet, radio waves, microwaves, gamma rays and thermal radiation.

The semiconducting quantum dot material may comprise one or more of PbS, CdSe, CdS, PbSe, ZnO, ZnS, CZTS, Cu₂S, Bi₂S₃, Ag₂S, Ag₂Se, HgTe, CdHgTe, InAs, InSb, Ge and CIS.

At least one of the outer first and second electrode layers may comprise one or more of a metal, an alloy, a metal oxide, graphene, reduced graphene oxide, gold, silver, copper, aluminium, indium tin oxide, zinc tin oxide and doped zinc oxide.

The memristive layer may comprise a sub-layer of transition metal oxide in contact with a sub-layer of transition metal chalcogenide. The sub-layer of transition metal oxide may comprise one or more of WOₙ, MoOₙ, ScOₙ, TiOₙ, HfOₙ, ZrOₙ, VOₙ, CrOₙ, MnOₙ, FeOₙ, CoOₙ, NiOₙ, NbOₙ, where n = 2-3. The sub-layer of transition metal chalcogenide may comprise one or more of WX₂, MoX₂, ScX₂, TiX₂, HfX₂, ZrX₂, VX₂, CrX₂, MnX₂, FeX2, CoX₂, NiX₂, NbX₂, TcX₂, ReX₂, PdX₂, PtX₂, where X = S, Se or Te. A variety of other memristive materials from the group of metal oxides, metal chalcogenides, metal halides and organic polymers may be used instead.

The memristive layer may be configured to have a resistance of 10⁶-10⁸Ω in the first resistance state and a resistance of 10²-10³Ω in the second resistance state.

The memristive layer may be configured to return to its previous resistance when a reverse voltage above a predefined threshold is applied thereto.

The memristive layer may be configured to return to its previous resistance automatically after a predefined period of time following removal of the applied voltage.

The memristive layer may be configured to exhibit a change in resistance when a voltage of 0.1-5V is applied thereto.

One or more of the materials, dimensions and fabrication conditions of the memristive layer may be configured to define the change in resistance with applied voltage.

The apparatus may comprise a substrate configured to support the stack.

The substrate may be one or more of substantially flexible, substantially stretchable and substantially compressible.

The substrate may comprise one or more polymeric materials.

The one or more polymeric materials may comprise at least one of polyimide, polyethylene naphthalate and polyethylene terephthalate.

The apparatus may be the stack. The apparatus may be one or more of an electronic device, a portable electronic device, a portable telecommunications device, a mobile phone, a personal digital assistant, a tablet, a phablet, a desktop computer, a laptop computer, a server, a smartphone, a smartwatch, smart eyewear, a photodetector, and a module for one or more of the same.

According to a further aspect, there is provided a method of using an apparatus,
the apparatus comprising a stack formed from outer first and second electrode layers and an intermediate third electrode layer, with a memristive layer positioned between the outer first and intermediate third electrode layers and a photoactive layer positioned between the outer second and intermediate third electrode layers,
wherein the outer first and second electrode layers are connected to a power supply to enable the application of a voltage to the memristive layer to change its resistance when the photoactive layer is exposed to incident electromagnetic radiation, and
wherein the outer first and intermediate third electrode layers are connected to a readout circuit to enable the resistance of the memristive layer to be determined, the resistance of the memristive layer providing an indication of one or more of the presence and magnitude of the incident electromagnetic radiation,

the method comprising determining one or more of the presence and magnitude of the incident electromagnetic radiation based on the resistance of the memristive layer.

According to a further aspect, there is provided a method of making an apparatus, the method comprising:
forming a stack from outer first and second electrode layers and an intermediate third electrode layer, with a memristive layer positioned between the outer first and intermediate third electrode layers and a photoactive layer positioned between the outer second and intermediate third electrode layers;
connecting the outer first and second electrode layers to a power supply to enable the application of a voltage to the memristive layer to change its resistance when the photoactive layer is exposed to incident electromagnetic radiation; and
connecting the outer first and intermediate third electrode layers to a readout circuit to enable the resistance of the memristive layer to be determined, the resistance of the memristive layer providing an indication of one or more of the presence and magnitude of the incident electromagnetic radiation.

The steps of any method disclosed herein do not have to be performed in the exact order disclosed, unless explicitly stated or understood by the skilled person.

Throughout the present specification, descriptors relating to relative orientation and position, such as "top", "bottom", "upper", "lower", "above" and "below", as well as any adjective and adverb derivatives thereof, are used in the sense of the orientation of the apparatus as presented in the drawings. However, such descriptors are not intended to be in any way limiting to an intended use of the described or claimed invention.

Corresponding computer programs for implementing one or more steps of the methods disclosed herein are also within the present disclosure and are encompassed by one or more of the described example embodiments.

One or more of the computer programs may, when run on a computer, cause the computer to configure any apparatus, including a circuit, controller, or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

One or more of the computer programs may be provided on a computer readable medium, which may be a physical computer readable medium such as a disc or a memory device, or may be embodied as a transient signal. Such a transient signal may be a network download, including an internet download.

The present disclosure includes one or more corresponding aspects, example embodiments or features in isolation or in various combinations whether or not specifically stated (including claimed) in that combination or in isolation. Corresponding means for performing one or more of the discussed functions are also within the present disclosure.

The above summary is intended to be merely exemplary and non-limiting.

### Brief Description of the Figures

A description is now given, by way of example only, with reference to the accompanying drawings, in which:-
Figure 1 shows one example of the present apparatus;
Figure 2 shows the apparatus of Figure 1 connected to a power supply configured to apply a steady voltage;
Figure 3 shows the apparatus of Figure 1 connected to a power supply configured to apply a pulsed voltage;
Figure 3b shows how the resistance of the memristive layer varies before and during exposure to the incident electromagnetic radiation;
Figures 4a-c show a method of making a two-dimensional array of stacks each having the layered structure of Figure 1;
Figure 5 shows another example of the present apparatus;
Figure 6 shows a method of using the present apparatus;
Figure 7 shows a method of making the present apparatus; and
Figure 8 shows a computer-readable medium comprising a computer program configured to perform, control or enable a method described herein.

### Description of Specific Aspects/Embodiments

In a typical photodetector, external circuitry is required for storing and reading out the signal (photocurrent). This is accomplished either by constant monitoring of changes in the circuit or by incorporating sample-and-hold storage capacitors. This approach can be energy consuming and increases the circuit complexity which is undesirable, especially in flexible devices where the patterning resolution is limited and pixel active area may need to be sacrificed in order to house the routing and storage capacitors.

There will now be described an apparatus and associated methods that may address this issue.

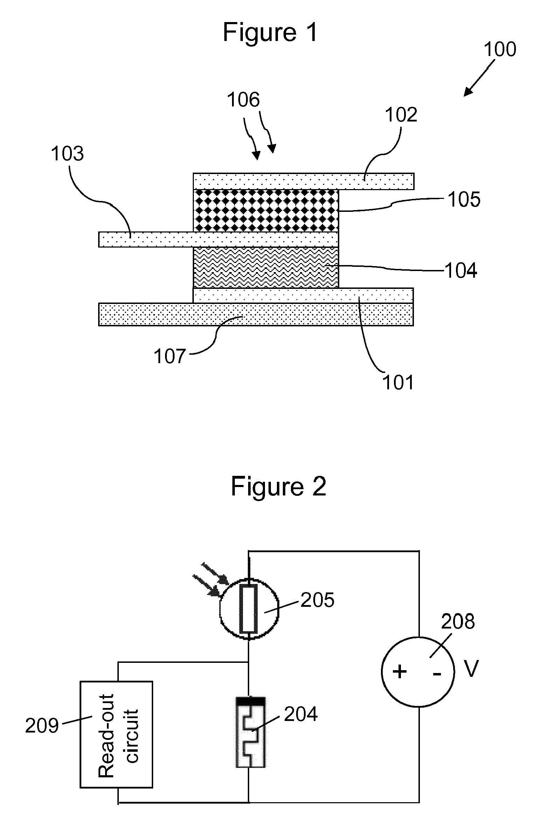

Figure 1 shows one example of the present apparatus. The apparatus comprises a stack 100 formed from outer first 101 and second 102 electrode layers and an intermediate third electrode layer 103, with a memristive layer 104 positioned between the outer first 101 and intermediate third 103 electrode layers and a photoactive layer 105 positioned between the outer second 102 and intermediate third 103 electrode layers. The outer first 101 and second 102 electrode layers are connectable (connection not shown) to a power supply to enable the application of a voltage to the memristive layer 104 to change its resistance when the photoactive layer 105 is exposed to incident electromagnetic radiation. In addition, the outer first 101 and intermediate third 103 electrode layers are connectable (connection not shown) to a readout circuit to enable the resistance of the memristive layer 104 to be determined, the resistance of the memristive layer 104 providing an indication of one or more of the presence and magnitude of the incident electromagnetic radiation 106. In this example, the apparatus also comprises a substrate 107 configured to support the stack 100, but this is not essential in all cases.

Figure 2 shows an equivalent circuit diagram for the apparatus of Figure 1 in which the photoactive layer 205 is represented by a photoresistor and the memristive layer 204 is represented by a memristor. Furthermore, the outer first and second electrode layers are connected to a power supply 208, and the outer first and intermediate third electrode layers are connected to a readout circuit 209. The photoactive layer 205 is configured to exhibit a decrease in resistance on exposure to the incident electromagnetic radiation, the decrease in resistance allowing the voltage from the power supply 208 to be applied to the memristive layer 204 to change its resistance (like a voltage divider).

In this example, the power supply 208 is configured to apply a steady voltage between the outer first and second electrode layers. Initially, the memristive layer 204 is in a first resistance state (e.g. having a resistance of 10⁶-10⁸Ω). In the absence of incident electromagnetic radiation, the resistance of the photoactive layer 205 is relatively high and the voltage applied to the memristive layer 204 is below the threshold voltage of the memristive layer 204 (e.g. 0.1-5V depending on one or more of the materials, dimensions and fabrication conditions of the memristive layer 204). Once the photoactive layer 205 is exposed to incident electromagnetic radiation, however, the resistance of the photoactive layer 205 decreases causing a voltage to be applied from the power supply 208 to the memristive layer 204 which exceeds the threshold voltage of the memristive layer 204. This causes the memristive layer 204 to switch from the first resistance state to a second lower resistance state (e.g. having a resistance of 10²-10³Ω). The change in resistance of the memristive layer 204 therefore provides an indication of the presence of the incident electromagnetic radiation (i.e. a qualitative measurement). Furthermore, if the resistance of the memristive layer 204 is pre-calibrated with the intensity of the incident electromagnetic radiation, it may also provide an indication of the intensity/magnitude of the electromagnetic radiation (i.e. a quantitative measurement).

The readout circuit 209 may be configured to measure the current flowing through the memristive layer 204 and determine the resistance based on the measured current and the voltage applied by the power supply 208 when the resistance of the photoactive layer 205 is known at the time of readout (e.g. if conducted in the dark). Alternatively, the readout circuit 209 may be configured to measure both the voltage coupled across, and the current flowing through, the memristive layer 204 such that the resistance of the memristive layer 204 can be determined irrespective of the resistance of the photoactive layer 205.

Once the memristive layer 204 has been read out, it may be switched back from the second resistance state to the first resistance state (i.e. reset) ready for future sensing operations. This may be achieved by applying a reverse voltage above a predefined threshold to the memristive layer 204 (e.g. using the readout circuit). Alternatively, the memristive layer 204 may be configured to switch back from the second resistance state to the first resistance state automatically after a predefined period of time following removal of the applied voltage.

The present apparatus provides a number of technical advantages over existing photodetectors. First of all, the incorporation of a memristive layer provides a non-volatile memory for storing the sensor data at lower power consumption than storage capacitors. This feature allows the presence and/or magnitude of the incident electromagnetic radiation to be determined at a later date/time rather than during or immediately after exposure. Secondly, forming a monolithic vertical stack (pixel) comprising the photoactive layer, the memristive layer and the electrode layers allows a greater number of pixels to be fabricated per unit area which increases the spatial resolution of the resulting photodetector. Thirdly, by using an intermediate third electrode layer between the photoactive and memristive layers, the resistance of the memristive layer can be determined directly without the need to correct for the resistance of the photoactive layer (as would be the case if the outer first and second electrode layers were used for readout).

Also, in certain embodiments (as will be discussed later), each layer of the stack may be fabricated using solution processing, which reduces the cost and complexity of the manufacturing process and facilitates mass production. The sharing of electrode layers and associated electronics (e.g. power supply, readout circuit and electrical connections) also helps to reduce the fabrication cost as well as the overall size of the device. In addition, in certain embodiments, the materials used to form the various layers may be compatible with plastic substrates, which allows the formation of flexible/stretchable devices.

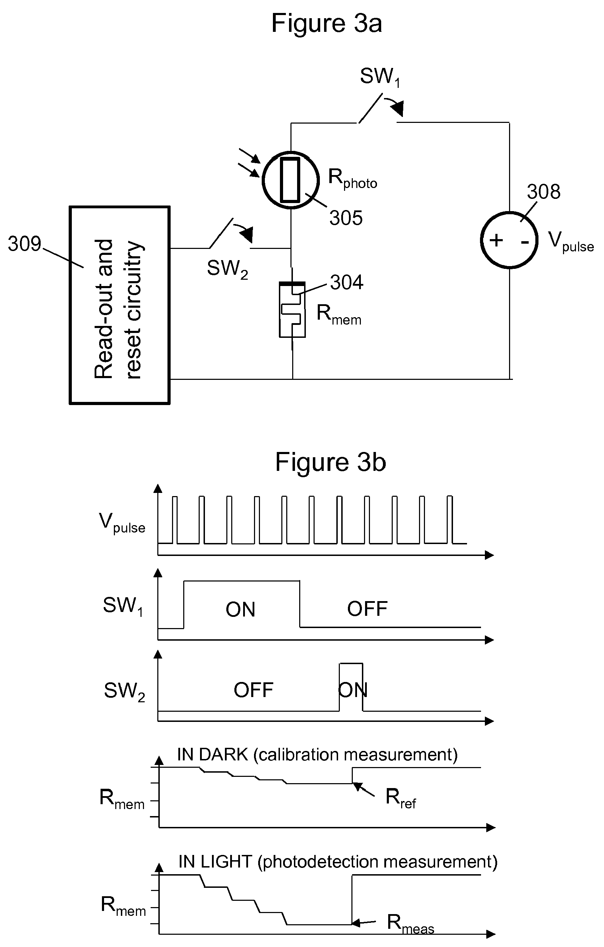

Figure 3a shows another example of the present apparatus in which the power supply 308 is configured to apply a pulsed voltage between the outer first and second electrode layers. In this example, the power supply 308 is connected to the stack via a first switch SW₁, and the readout circuit 309 is connected to the stack via a second switch SW₂. When the first switch SW₁ is closed, the power supply 308 applies the pulsed voltage causing a gradual change in the resistance Rₘₑₘ of the memristive layer 304 proportional to the intensity of the incident electromagnetic radiation. The power supply 308 is configured to apply the pulsed voltage at a frequency and amplitude (typically around the threshold level of the memristive layer 304) sufficient to reduce the resistance Rₘₑₘ of the memristive layer 304 in a step-wise manner. Alternatively, the pulsed voltage may be applied by providing a steady voltage and opening/closing the first switch SW₁ at a predetermined frequency.

This procedure should ideally be carried out in the absence of the incident electromagnetic radiation first (i.e. in the dark) for calibration purposes, and then in the presence of the incident electromagnetic radiation (i.e. in the light) for the actual measurement. In each case, the first switch SW₁ is reopened once a predefined period of time has lapsed in order to decouple the power supply 308 from the stack and retain the resistance Rₘₑₘ of the memristive layer 304 at that time. The resistance Rₘₑₘ of the memristive layer 304 can then be read out using the readout circuit 309 by closing the second switch SW₂.

Figure 3b shows how the resistance Rₘₑₘ of the memristive layer 304 typically varies before and during exposure to the incident electromagnetic radiation. As can be seen from the graphs, the resistance Rₘₑₘ of the memristive layer 304 decreases in larger steps when the photoactive layer 305 is exposed to the incident electromagnetic radiation. This is because a larger voltage from the power supply 308 is coupled to the memristive layer 304 as a result of the lower resistance Rₚₕₒₜₒ of the photoactive layer 305. The intensity of the incident electromagnetic radiation can be deduced from the difference ΔR in the resistance measurements taken before R_{ref} and during Rₘₑₐₛ exposure, i.e. ΔR=Rₘₑₐₛ-R_{ref}. After the intensity of the incident electromagnetic radiation has been determined, the resistance Rₘₑₘ of the memristive layer 304 may be reset by applying a reverse voltage greater than the threshold level using the readout circuit 309.

In some embodiments, the apparatus may comprise an illumination source configured to expose the photoactive layer with electromagnetic radiation for a predefined period of time. In this scenario, the illumination source may be configured to emit x-rays, visible light, infrared, ultraviolet, radio waves, microwaves, gamma rays or thermal radiation, and the exposure time may be controlled using a shutter or the illumination source itself. Additionally or alternatively, the power supply could be used to control the period of time during which the stack is operable to detect the incident electromagnetic radiation (which may be provided by the illumination source or an external source of electromagnetic radiation).

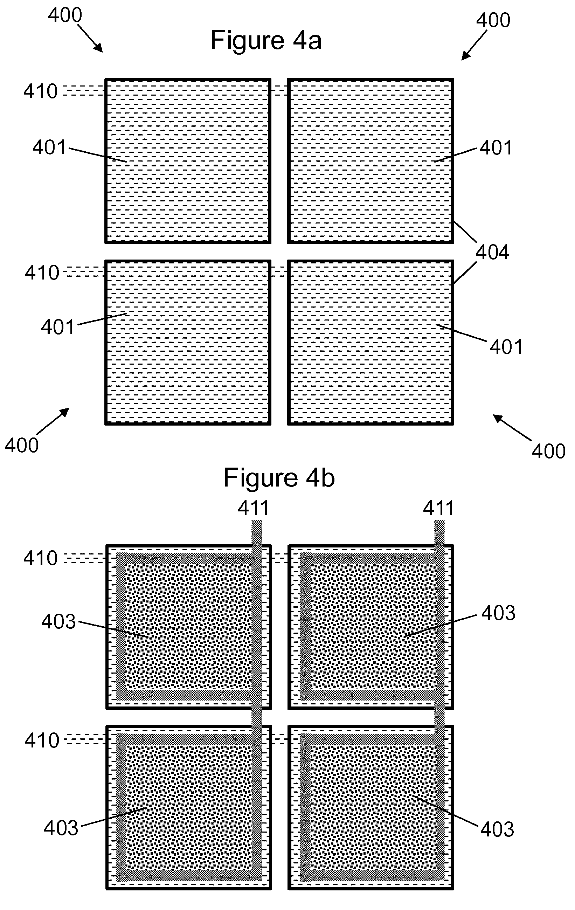

Figures 4a-c show a method of making a two-dimensional array of individually addressable stacks 400 each having the layered structure of Figure 1. A typical photodetector would comprise millions of these stacks 400 (or pixels), but four are shown here for illustrative purposes. The process begins by forming the outer first electrode layer 401 followed by the overlying memristive layer 404 (Figure 4a). Formation of the outer first electrode layer 401 can be achieved by depositing an electrode material (e.g. a metal, an alloy, graphene, reduced graphene oxide, gold, silver, copper or aluminium) onto a supporting substrate using one or more vacuum (e.g. sputtering, atomic layer deposition, chemical vapour deposition or physical vapour deposition) or solution processing (e.g. dispensing, screen printing, offset printing, gravure printing, flexography, aerosol jet printing or inkjet printing) techniques. The supporting substrate may comprise one or more resilient polymeric materials such as polyimide, polyethylene naphthalate or polyethylene terephthalate to facilitate reversible bending, stretching or compressing of the apparatus. As can be seen in Figure 4a, the outer first electrode layers 401 of each stack 400 are connected row-wise by metallic routing 410.

Once the outer first electrode layer 401 has been formed, the memristive layer 404 can be produced by depositing a sub-layer of transition metal chalcogenide (e.g. using one or more solution processes such as spin coating, slot die-coating, spray coating, soft lithography, transfer printing, drop-casting, aerosol jet printing, inkjet printing and thin film transfer) and oxidising this transition metal chalcogenide to form a sub-layer of transition metal oxide. The sub-layer of transition metal chalcogenide may comprise one or more of WX₂, MoX₂, ScX₂, TiX₂, HfX₂, ZrX₂, VX₂, CrX₂, MnX₂, FeX₂, CoX₂, NiX₂, NbX₂, TcX₂, ReX₂, PdX₂, PtX₂, where X = S, Se or Te, and the sub-layer of transition metal oxide may comprise one or more of WOₙ, MoOₙ, ScOₙ, TiOₙ, HfOₙ, ZrOₙ, VOₙ, CrOₙ, MnOₙ, FeOₙ, CoOₙ, NiOₙ, NbOₙ, where n = 2-3. A variety of other memristive materials from the group of metal oxides, metal chalcogenides, metal halides and organic polymers may be used instead.

The intermediate third electrode layer 403 is then formed on top of the memristive layer 404 followed by routing 411 for the intermediate third electrode layer 403 (Figure 4b). The intermediate third electrode layer 403 may comprise one or more metal nanowires (e.g. silver nanowires) which can be deposited from solution using any of the above-mentioned printing or coating techniques. The use of metal nanowires serves to limit the current flowing through the stack 400 to the nA level, thus reducing leakage current in the off-state and preventing damage to the memristive layer 404 in the on-state. Memristive and photoactive materials often function best when they are in contact with low work function and high work function metals, respectively. In some cases, therefore, the intermediate third electrode layer 403 may comprise a first sub-layer (e.g. silver nanowires) adjacent to the memristive layer 404 and a second sub-layer (e.g. gold nanowires) adjacent to the photoactive layer 405, the first sub-layer having a lower work function than the second sub-layer. In this scenario, the first and second sub-layers may be separated by a third sub-layer such that the first and second sub-layers can be used for interfacing the respective memristive 404 and photoactive 405 layers and the third sub-layer can be used for reading out the resistance of the memristive layer 404. As can be seen in Figure 4b, the intermediate third electrode layers 403 of each stack 400 are connected column-wise by metallic routing 411.

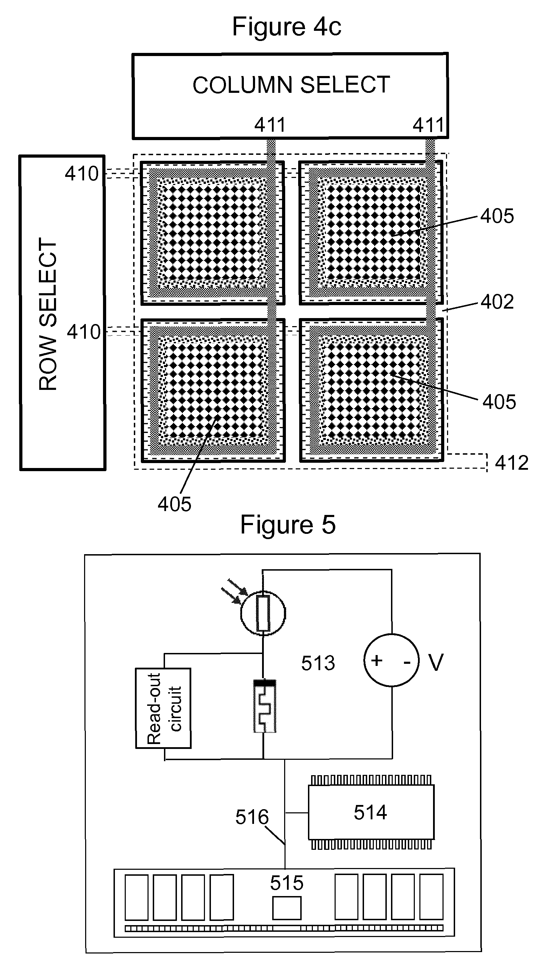

Next, the photoactive layer 405 is formed on top of the intermediate third electrode layer 403 and associated routing 411 followed by the outer second electrode layer 402 (Figure 4c). The photoactive layer 405 may comprise a semiconducting quantum dot material configured to generate electron-hole pairs on exposure to the incident electromagnetic radiation to cause a decrease in resistance. Such materials may be deposited from solution (in which the quantum dots are separated by surface ligands) using any of the above-mentioned printing or coating processes. The specific quantum dot material used depends on the type of photodetector. For example, the quantum dot material may be a photoconductive material (i.e. to form a photoconductor) configured such that each photon of the incident electromagnetic radiation excites an electron from the valence band to the conduction band to produce a photocurrent.

In another example, the quantum dot material may comprise first and second semiconducting quantum dot materials configured to form a photodiode. In this scenario, the first and second quantum dot materials create a pn-junction, and any photons absorbed in the depletion region of the pn-junction (or one diffusion length away) generate electron-hole pairs which are swept from the junction by the built-in electric field of the depletion region to produce a photocurrent.

In a further example, the semiconducting quantum dot material may be configured to form a Schottky photodiode with the outer second electrode layer 402 or the intermediate third electrode layer 403. A Schottky photodiode comprises a metal-semiconductor junction in which a positive depletion region is formed in the semiconductor by the flow of electrons to the metal. As with a semiconductor photodiode, electron-hole pairs are generated when photons are absorbed in the depletion region (or one diffusion length away) and are swept from the junction by the built-in electric field of the depletion region to produce a photocurrent.

One or more of the material, size and shape of the semiconducting quantum dots may be configured such that the electron-hole pairs are generated on exposure to at least one of the following types of electromagnetic radiation: x-rays, visible light, infrared, ultraviolet, radio waves, microwaves, gamma rays and thermal radiation. Examples of suitable quantum dot materials include PbS, CdSe, CdS, PbSe, ZnO, ZnS, CZTS, Cu₂S, Bi₂S₃, Ag₂S, Ag₂S, HgTe, CdHgTe, InAs, InSb, Ge and CIS.

The outer second electrode layer 402 in this example is common to all stacks 400 and is configured to be substantially transparent to the incident electromagnetic radiation to enable interaction of the electromagnetic radiation with the underlying photoactive layer 405. The outer second electrode layer 402 may comprise one or more of a metal, an alloy, graphene, reduced graphene oxide, gold, silver, copper, aluminium and indium tin oxide. Furthermore, these materials may be deposited as a continuous film or in the form of one or more nanowires.

In use, a steady or pulsed voltage is applied to the outer first electrode layer 401 of each stack with reference to the common outer second electrode layer 402 (which can be connected to ground via the indicated routing 412 during exposure to the incident electromagnetic radiation). After exposure, the resistance of the respective memristive layers 404 can be read out sequentially by selecting one row 410 and one column 411 at a time (i.e. by coupling between the outer first 401 and intermediate third 403 electrode layers of each stack 400 in turn via the associated routing 410, 411).

The apparatus shown in Figures 4a-c may comprise additional dielectric layers configured to prevent short-circuiting of the routing conductors 410-412. In addition, whilst a two-dimensional array is illustrated, the apparatus may comprise a plurality of stacks 400 configured to form a one, two or three dimensional array. A three-dimensional array could be created, for example, by forming the above-mentioned stacks 400 on the external surfaces of a three-dimensional substrate (e.g. in the shape of a cube or sphere).

Figure 5 shows another example of the present apparatus. The apparatus may be one or more of an electronic device, a portable electronic device, a portable telecommunications device, a mobile phone, a personal digital assistant, a tablet, a phablet, a desktop computer, a laptop computer, a server, a smartphone, a smartwatch, smart eyewear, a photodetector, and a module for one or more of the same. In the example shown, the apparatus comprises the various components described previously (denoted collectively by reference numeral 513), a processor 514 and a storage medium 515, which are electrically connected to one another by a data bus 516.

The processor 514 is configured for general operation of the apparatus by providing signalling to, and receiving signalling from, the other components to manage their operation. The storage medium 515 is configured to store computer code configured to perform, control or enable operation of the apparatus. The storage medium 515 may also be configured to store settings for the other components. The processor 514 may access the storage medium 515 to retrieve the component settings in order to manage the operation of the other components.

Under the control of the processor 514, the power supply is configured to apply a voltage between the outer first and second electrode layers to enable the resistance of the memristive layer to be varied when the photoactive layer is exposed to incident electromagnetic radiation. In addition, under the control of the processor 514, the readout circuit is configured to apply a voltage between the outer first and intermediate third electrode layers to enable the resistance of the memristive layer to be determined. The readout circuit may be configured to measure the current flowing through the memristive layer and determine the resistance using the measured current and applied voltage. In some cases, this calculation may be performed by the processor 514 rather than the readout circuit.

Based on the resistance of the memristive layer, the processor 514 is configured to determine one or more of the presence and magnitude of the incident electromagnetic radiation. In order to determine the presence/magnitude of the incident electromagnetic radiation, the processor 514 may use predetermined calibration data saved in the storage medium 515 which correlates the intensity of the electromagnetic radiation with the resistance of the memristive layer.

The processor 514 may be a microprocessor, including an Application Specific Integrated Circuit (ASIC). The storage medium 515 may be a temporary storage medium such as a volatile random access memory. On the other hand, the storage medium 515 may be a permanent storage medium such as a hard disk drive, a flash memory, or a non-volatile random access memory. The power supply may comprise one or more of a primary battery, a secondary battery, a capacitor, a supercapacitor and a battery-capacitor hybrid.

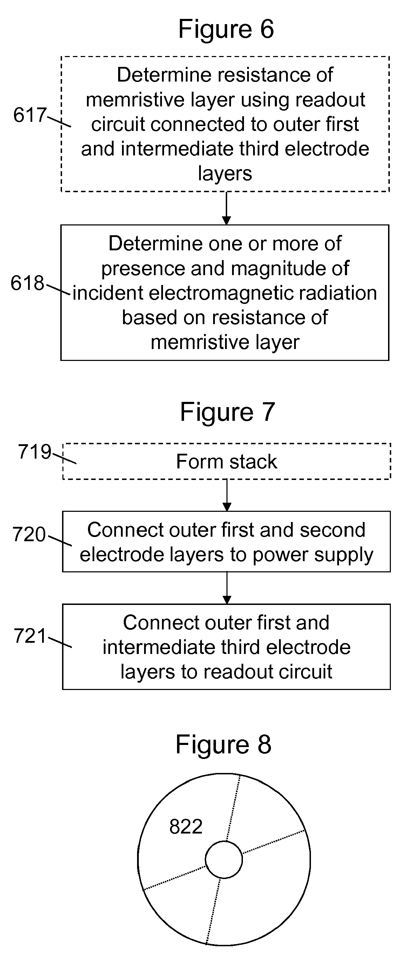

Figure 6 shows schematically the main steps 617-618 of a method of using the present apparatus. The method generally comprises: determining the resistance of the memristive layer using the readout circuit connected to the outer first and intermediate third electrode layers 617; and determining one or more of the presence and magnitude of the incident electromagnetic radiation based on the resistance of the memristive layer 618. As indicated by the dashed box, step 617 may be performed separately from step 618 and is therefore optional.

Figure 7 shows schematically the main steps 719-721 of a method of making the present apparatus. The method generally comprises: forming the above-mentioned stack 719; connecting the outer first and second electrode layers to the power supply 720; and connecting the outer first and intermediate third electrode layers to the readout circuit 721. As indicated by the dashed box, step 719 may be performed separately from steps 720 and 721 and is therefore optional.

Figure 8 illustrates schematically a computer/processor readable medium 822 providing a computer program according to one embodiment. The computer program may comprise computer code configured to perform, control or enable one or more of the method steps 617-721 of Figure 6 or 7. In this example, the computer/processor readable medium 822 is a disc such as a digital versatile disc (DVD) or a compact disc (CD). In other embodiments, the computer/processor readable medium 822 may be any medium that has been programmed in such a way as to carry out an inventive function. The computer/processor readable medium 822 may be a removable memory device such as a memory stick or memory card (SD, mini SD, micro SD or nano SD).

Other embodiments depicted in the figures have been provided with reference numerals that correspond to similar features of earlier described embodiments. For example, feature number 1 can also correspond to numbers 101, 201, 301 etc. These numbered features may appear in the figures but may not have been directly referred to within the description of these particular embodiments. These have still been provided in the figures to aid understanding of the further embodiments, particularly in relation to the features of similar earlier described embodiments.

It will be appreciated to the skilled reader that any mentioned apparatus/device and/or other features of particular mentioned apparatus/device may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/functional units.

In some embodiments, a particular mentioned apparatus/device may be pre-programmed with the appropriate software to carry out desired operations, and wherein the appropriate software can be enabled for use by a user downloading a "key", for example, to unlock/enable the software and its associated functionality. Advantages associated with such embodiments can include a reduced requirement to download data when further functionality is required for a device, and this can be useful in examples where a device is perceived to have sufficient capacity to store such pre-programmed software for functionality that may not be enabled by a user.

It will be appreciated that any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).

It will be appreciated that any "computer" described herein can comprise a collection of one or more individual processors/processing elements that may or may not be located on the same circuit board, or the same region/position of a circuit board or even the same device. In some embodiments one or more of any mentioned processors may be distributed over a plurality of devices. The same or different processor/processing elements may perform one or more functions described herein.

It will be appreciated that the term "signalling" may refer to one or more signals transmitted as a series of transmitted and/or received signals. The series of signals may comprise one, two, three, four or even more individual signal components or distinct signals to make up said signalling. Some or all of these individual signals may be transmitted/received simultaneously, in sequence, and/or such that they temporally overlap one another.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/embodiments may consist of any such individual feature or combination of features. In view of the foregoing description it will be evident to a person skilled in the art that various modifications may be made within the scope of the disclosure.

While there have been shown and described and pointed out fundamental novel features as applied to different embodiments thereof, it will be understood that various omissions and substitutions and changes in the form and details of the devices and methods described may be made by those skilled in the art without departing from the spirit of the invention. For example, it is expressly intended that all combinations of those elements and/or method steps which perform substantially the same function in substantially the same way to achieve the same results are within the scope of the invention. Moreover, it should be recognized that structures and/or elements and/or method steps shown and/or described in connection with any disclosed form or embodiment may be incorporated in any other disclosed or described or suggested form or embodiment as a general matter of design choice. Furthermore, in the claims means-plus-function clauses are intended to cover the structures described herein as performing the recited function and not only structural equivalents, but also equivalent structures. Thus although a nail and a screw may not be structural equivalents in that a nail employs a cylindrical surface to secure wooden parts together, whereas a screw employs a helical surface, in the environment of fastening wooden parts, a nail and a screw may be equivalent structures.

## Claims

1. An apparatus comprising a stack formed from outer first and second electrode layers and an intermediate third electrode layer, with a memristive layer positioned between the outer first and intermediate third electrode layers and a photoactive layer positioned between the outer second and intermediate third electrode layers,
wherein the outer first and second electrode layers are connected to a power supply to enable the application of a voltage to the memristive layer to change its resistance when the photoactive layer is exposed to incident electromagnetic radiation, and
wherein the outer first and intermediate third electrode layers are connected to a readout circuit to enable the resistance of the memristive layer to be determined, the resistance of the memristive layer providing an indication of one or more of the presence and magnitude of the incident electromagnetic radiation.

2. The apparatus of claim 1, wherein the photoactive layer is configured to exhibit a decrease in resistance on exposure to the incident electromagnetic radiation, the decrease in resistance allowing the voltage from the power supply to be applied to the memristive layer to change its resistance.

3. The apparatus of claim 2, wherein the photoactive layer comprises a semiconducting quantum dot material configured to generate electron-hole pairs on exposure to the incident electromagnetic radiation to cause the decrease in resistance.

4. The apparatus of claim 3, wherein the semiconducting quantum dot material is configured to form a photoconductor.

5. The apparatus of claim 3, wherein the semiconducting quantum dot material comprises first and second semiconducting quantum dot materials configured to form a photodiode.

6. The apparatus of claim 3, wherein the semiconducting quantum dot material is configured to form a Schottky photodiode with the outer second electrode layer or the intermediate third electrode layer.

7. The apparatus of any preceding claim, wherein the intermediate third electrode layer comprises a first sub-layer adjacent to the memristive layer and a second sub-layer adjacent to the photoactive layer, the first sub-layer having a lower work function than the second sub-layer.

8. The apparatus of claim 7, wherein the first and second sub-layers are separated by a third sub-layer, the first and second sub-layers configured for interfacing the respective memristive and photoactive layers, the third sub-layer configured for reading out the resistance of the memristive layer.

9. The apparatus of any preceding claim, wherein the intermediate third electrode layer comprises one or more metal nanowires.

10. The apparatus of any preceding claim, wherein the outer second electrode layer is substantially transparent to the incident electromagnetic radiation.

11. The apparatus of any preceding claim, wherein the power supply is configured to apply a steady voltage to switch the memristive layer from a first resistive state to a second lower resistance state, or a pulsed voltage to vary the resistance of the memristive layer more gradually in a step-wise manner.

12. The apparatus of any preceding claim, wherein the apparatus comprises a plurality of stacks configured to form a one, two or three dimensional array.

13. The apparatus of claim 12, wherein the plurality of stacks share a common outer second electrode layer, and the outer first and intermediate third electrode layers of each stack are individually addressable to enable the resistance of a particular memristive layer of the array to be determined.

14. A method of using an apparatus,
the apparatus comprising a stack formed from outer first and second electrode layers and an intermediate third electrode layer, with a memristive layer positioned between the outer first and intermediate third electrode layers and a photoactive layer positioned between the outer second and intermediate third electrode layers,
wherein the outer first and second electrode layers are connected to a power supply to enable the application of a voltage to the memristive layer to change its resistance when the photoactive layer is exposed to incident electromagnetic radiation, and
wherein the outer first and intermediate third electrode layers are connected to a readout circuit to enable the resistance of the memristive layer to be determined, the resistance of the memristive layer providing an indication of one or more of the presence and magnitude of the incident electromagnetic radiation,
the method comprising determining one or more of the presence and magnitude of the incident electromagnetic radiation based on the resistance of the memristive layer.

15. A method of making an apparatus, the method comprising:
forming a stack from outer first and second electrode layers and an intermediate third electrode layer, with a memristive layer positioned between the outer first and intermediate third electrode layers and a photoactive layer positioned between the outer second and intermediate third electrode layers;
connecting the outer first and second electrode layers to a power supply to enable the application of a voltage to the memristive layer to change its resistance when the photoactive layer is exposed to incident electromagnetic radiation; and
connecting the outer first and intermediate third electrode layers to a readout circuit to enable the resistance of the memristive layer to be determined, the resistance of the memristive layer providing an indication of one or more of the presence and magnitude of the incident electromagnetic radiation.
